# EUROPÄISCHE PATENTSCHRIFT

(11) **EP 1 222 318 B1**
(45) Veröffentlichungstag und Bekanntmachung des Hinweises auf die Patenterteilung: **31.08.2005**
(21) Anmeldenummer: 00958044.0
(22) Anmeldetag: 13.09.2000
(51) Int. Cl.: C23C 2/40, B05D 7/14, C23C 14/56

(54) **ANLAGE ZUM BESCHICHTEN EINES METALLBANDES SOWIE**
INSTALLATION FOR COATING A METAL STRIP
INSTALLATION PERMETTANT DE RECOUVRIR UNE BANDE METALLIQUE

(30) Priorität: 13.09.1999 AT 156699
(43) Veröffentlichungstag der Anmeldung: 17.07.2002
(73) Patentinhaber: VOEST-ALPINE Industrieanlagenbau GmbH, 4020 Linz (AT)
(72) Erfinder: MEDITZ, Rainer, A-4040 Linz (AT)
(74) Vertreter: Kopecky, Helmut
(86) Internationale Anmeldenummer: PCT/AT2000/000245
(87) Internationale Veröffentlichungsnummer: WO 2001/020054

(56) Entgegenhaltungen:
- GB-A- 1 254 602
- GB-A- 1 362 735
- US-A- 2 267 877
- US-A- 3 891 471

## Beschreibung

Die Erfindung betrifft eine Anlage zum Beschichten eines Metallbandes, insbesondere zum metallischen Beschichten eines Stahlbandes, mit einer Bundabwickelstation, einer Durchlauf-Beschichtungskammer und einer nach der Durchlauf-Beschichtungskammer angeordneten Bundaufwickelstation sowie Bandführungseinrichtungen zwischen der Bundabwickelstation und der Durchlauf-Beschichtungskammer sowie der Durchlauf-Beschichtungskammer und der Bundaufwickelstation.

Es ist bekannt - z.B. aus der GB 1 254 602 A1 -, Metallbänder kontinuierlich zu beschichten. So existieren kontinuierlich arbeitende Metallbeschichtungsanlagen zum kontinuierlichen Verzinken, Verzinnen, Aluminisieren, wobei vor dem Metallbeschichtungsprozeß gegebenenfalls Rekristallisationsglühöfen zur kontinuierlichen Bandglühung vorgesehen sind. Hierbei werden die einzelnen Metallbänder aneinandergeschweißt, seltener auch durch z.B. Heften aneinandergefügt, und kontinuierlich durch die Anlage geführt. Das Aneinanderschweißen der Metallbänder hat den Sinn, den Einfädelvorgang eines Metallbandes durch eine solche Anlage zu vermeiden. Ein Einfädeln des Bandanfanges des Metallbandes wird insbesondere dadurch erschwert, als üblicherweise das Band durch einen mit schmelzflüssigem Metall gefüllten Kessel zuzuführen und senkrecht aus diesem herauszuziehen ist. Ein Anbringen von Einfädelhilfen wäre schwierig. Dieses Aneinanderschweißen der Metallbänder erfordert jedoch Schweißmaschinen, meist Doppelhaspel-Ein- und Auslaufgruppen, Einlaufbandspeicher, Auslaufbandspeicher etc., also einen hohen Investitionsaufwand.

Der Vorteil von Anlagen zur kontinuierlichen Beschichtung dieser Art liegt in der kurzen Durchlaufzeit eines Metallbandes durch die Anlage sowie - im Falle einer dem Beschichten vorangehenden Wärmebehandlung - den hohen erzielbaren Abkühlgeschwindigkeiten und in dem homogenen Glühergebnis über die gesamte Länge des Metallbandes. Nachteilig sind die bereits erwähnten hohen Investitionskosten sowie eine relativ unflexible Programmgestaltung, da von Bund zu Bund nur geringe Dimensionssprünge zulässig sind, andernfalls würden die mechanischen Eigenschaften des Metallbandes negativ beeinflußt.

Aus der US 3,891,471 A ist es bekannt, ein Metallband vor dem Beschichten in einzelne Tafeln zu zerteilen und diese durch Beschichtungsenrichtungen einzeln hindurchzuführen und nachfolgend zu stapeln.

Die Erfindung bezweckt die Vermeidung der Nachteile und Schwierigkeiten dieser bekannten Beschichtungsverfahren und stellt sich die Aufgabe, eine Anlage der eingangs beschriebenen Art zu schaffen, welche den Nachteil des Aneinanderschweißens vermeiden lässt und eine sehr flexible Programmgestaltung ermöglicht.

Diese Aufgabe wird erfindungsgemäß dadurch gelöst, daß Bandführungseinrichtungen mit Gasdüsen zur Erzeugung eines das Metallband unterstützenden Gaspolsters zumindest innerhalb der Durchlauf-Beschichtungskammer vorgesehen sind.

Bei Verwendung eines Gaspolsters als Bandführungseinrichtung sind zweckmäßig zur Führung des Bandanfanges in der Durchlauf-Beschichtungskammer an sich quer zur Längserstreckung der Durchlauf-Beschichtungskammer erstreckenden Gasdüsenbalken angeordnete Gasdüsen vorgesehen, wobei vorteilhaft in der Durchlauf-Beschichtungskammer zusätzlich zu den Gasdüsen zur Bandführung geeignete Rollenstützeinrichtungen vorgesehen sind, vorzugsweise in größerem Abstand voneinander und unter Zwischenschaltung von Gasdüsen.

Zur Erzeugung einer den Bandanfang des Metallbandes versteifenden Querkrümmung ist zweckmäßig eine Biegeeinrichtung vor der Durchlauf-Beschichtungskammer vorgesehen.

Vorzugsweise ist die Beschichtungskammer mit einer Einrichtung zum Aufsprühen oder Bedampfen oder Roll-coaten des Beschichtungsmaterials versehen.

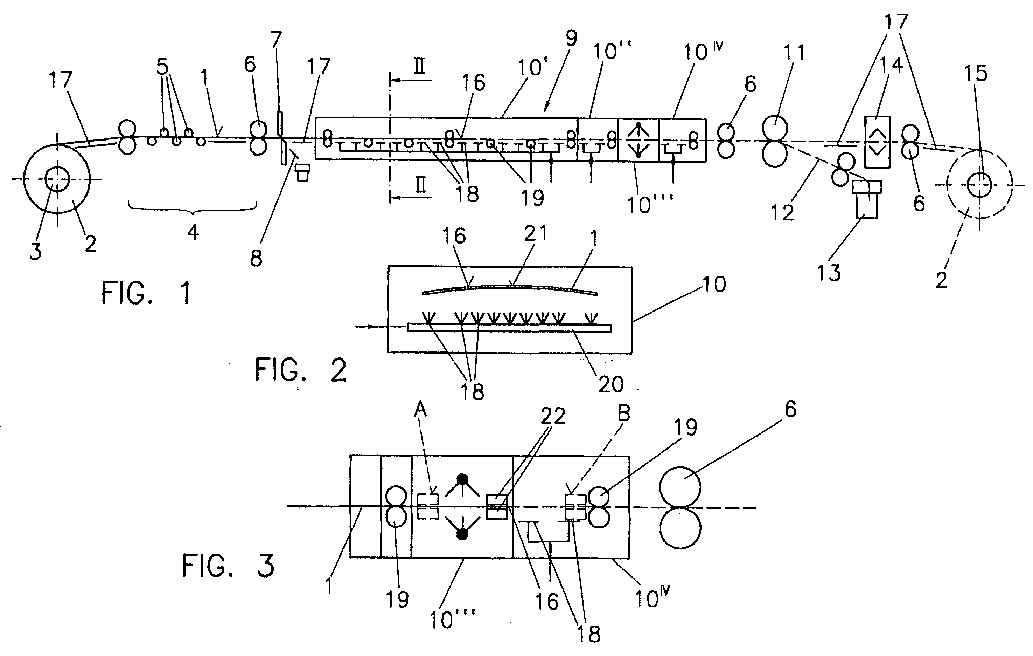

Die Erfindung ist nachfolgend anhand zweier Ausführungsbeispiele näher erläutert, wobei Fig. 1 eine Bandbeschichtungsanlage nach einer ersten Ausführungsform für ein Stahlband, Fig. 2 einen Querschnitt gemäß der Linie II-II der Fig. 1 und Fig. 3 eine weitere Ausführungsform einer Bandbeschichtungsanlage veranschaulichen.

Das zu behandelnde Metallband 1, im dargestellten Ausführungsbeispiel ein Stahlband, ist zu einem Bund 2 gewickelt und auf einer Abhaspel 3 gelagert. Von der Abhaspel 3 wird das Metallband 1 über einen sogenannten Einlaufteil 4, der mit Stützwalzen 5 und Treibwalzenpaaren 6 bestückt ist, zu einer Ablängvorrichtung 7 zum Abtrennen von gegebenenfalls unregelmäßig ausgebildeten Anfangs- und Endteilen 8 zugeführt. Von dort gelangt das Metallband in eine Durchlauf-Beschichtungseinrichtung 9, die eine nach außen isolierte Durchlauf-Beschichtungskammer 10 aufweist. Die Durchlauf-Beschichtungskammer 10 ist mehrfach unterteilt, wobei der erste Teil 10' zum Aufheizen des Metallbandes 1, der nachfolgende Bereich 10" zum Abkühlen des Metallbandes 1 und der diesem nachgeordnete Teil 10"' für die Metallbeschichtung vorgesehen ist. Der metallische Beschichtungswerkstoff wird dabei in einem Spritzbeschichtungsprozeß in schmelzflüssiger Form fein verteilt auf das Metallband 1 aufgebracht; der Beschichtungswerkstoff könnte auch durch Bedampfen oder Roll-coaten auf das Metallband 1 aufgebracht werden. Der letzte Teil 10^{IV} der Durchlauf-Beschichtungskammer 10 dient wiederum zum Abkühlen des Metallbandes 1.

Anschließend an die Durchlauf-Beschichtungskammer 10 sind weitere Förderwalzenpaare 6 vorgesehen sowie eine Besäumschere 11, wobei die Abfallteile 12 in einem Behälter 13 gesammelt werden. Das Metallband 1 gelangt dann über eine Einölmaschine 14 zu einer Aufhaspel 15, wo es wiederum zu einem Bund gewickelt wird.

Der Bandanfang 16 wird außerhalb der Durchlauf-Beschichtungseinrichtung 9 ausgehend von der Abhaspel 3 bis zum Beginn der Durchlauf-Beschichtungskammer 10 und zwischen den Treibwalzenpaaren 6 über starr angeordnete Bandführungen 17 gleiten gelassen. Innerhalb der Durchlauf-Beschichtungskammer 10 sind Gasdüsen 18 zur Unterstützung des Bandanfanges 16 vorgesehen, so daß der Bandanfang 16 des Metallbandes 1 problemlos von Stützrolle 19 zu Stützrolle 19 - die in größerem Abstand im Inneren der Durchlauf-Beschichtungskammer 10 vorgesehen sind - mit Hilfe der vor der Durchlauf-Beschichtungseinrichtung 9 angeordneten Förderwalzenpaare 6 förderbar ist.

Zweckmäßig werden die Gasdüsen 18 im Aufheizteil 10' mit Heißgas und im Abkühlteil 10" mit Kaltgas versorgt. Das über die Gasdüsen 18 eingebrachte Gas bildet einen den Bandanfang 16 tragenden bzw. unterstützenden Gaspolster, so daß Verformungen des nur eine geringe Festigkeit aufweisenden Bandanfanges 16 infolge der Schwerkraft und der hohen Temperatur in der Aufheizzone vermieden werden und ein einwandfreies Einfädeln des Bandanfanges 16 gewährleistet ist.

Ist eine gute Wärmeübertragung (z.B. schnelles Erwärmen oder Abkühlen) oder eine definierte Bandlage erforderlich (z.B. zum Erleichtern eines Durchtrittes des Metallbandes 1 durch einen Schlitz), so kann zusätzlich eine Gasbeaufschlagung des Metallbandes 1 von oben vorgesehen sein.

Die Gasdüsen 18 sind, wie aus Fig. 2 zu ersehen ist, an sich quer zur Längsrichtung der Durchlauf-Beschichtungskammer 10 erstreckenden Gasdüsenbalken 20 angeordnet, so daß das Metallband 1 über seine gesamte Breite unterstützt ist. Hierbei sind im Zentrum, also im Bereich der Mittellängsachse des Metallbandes 1, die Gasdüsen 18 enger gesetzt, wodurch mit relativ wenig Gas ein gut stützender Gaspolster erzeugt werden kann.

Um dem Metallband 1 eine Querkrümmung, wie sie in Fig. 2 veranschaulicht ist, zu erteilen, ist zweckmäßig das letzte Treibwalzenpaar 6 vor der Durchlauf-Beschichtungskammer 10 entsprechend der zu erzielenden Querkrümmung ausgebildet. Es dient dann als Biegeeinrichtung zum Biegen des Metallbandes 1 um seine Längsachse. Die Querkrümmung wird hierbei derart erzeugt, daß der konvexe Teil 21 nach oben gerichtet ist, wodurch eine besonders effektive Stützwirkung durch den Gaspolster erzielt werden kann.

Gemäß der in Fig. 3 dargestellten Ausführungsform wird das Metallband 1 durch den Teil 10"' für die Metallbeschichtung mittels Klemmbacken 22 geführt, die das Metallband 1 randseitig klemmen und dann unter Verbringen der Klemmbacken 22 in Längsrichtung der Durchlauf-Beschichtungskammer 10 fördern. Die Klemmbacken 22 werden hierbei von der in Fig. 3 mit strichlierten Linien dargestellten Position A in die ebenfalls mit strichlierten Linien dargestellte Position B verbracht und anschließend im geöffneten Zustand, also unter Loslassen des Randbereiches des Metallbandes 1, wiederum zurück in die Ausgangsposition A bewegt. Durch Hintereinanderschalten mehrerer solcher Klemmbacken 22 kann das Metallband 1 kontinuierlich durch die Durchlauf-Beschichtungskammer 10 gefördert werden.

Die Erfindung bezieht sich auch auf Metallbeschichtungsanlagen ohne Rekristallisationsschritt, wobei in der Durchlauf-Beschichtungskammer 10 in einem ersten Teil 10' lediglich eine Erwärmung des Metallbandes 1 auf eine Temperatur nahe der für die Beschichtung erforderlichen Temperatur, beispielsweise der Zinkbadtemperatur erfolgt, wie es üblich ist für zum Beispiel Warmband, vorgeglühtes aber auch walzhartes Kaltband.

## Patentansprüche

1. Anlage zum Beschichten eines Metallbandes (1), insbesondere zum metallischen Beschichten eines Stahlbandes, mit einer Bundabwickelstation (2), einer Durchlauf-Beschichtungskammer (10) und einer nach der Durchlauf-Beschichtungskammer (10) angeordneten Bundaufwickelstation (15) sowie Bandführungseinrichtungen (17) zwischen der Bundabwickelstation (2) und der Durchlauf-Beschichtungskammer (10) sowie der Durchlauf-Beschichtungskammer (10) und der Bundaufwickelstation (15), **dadurch gekennzeichnet, daß** Bandführungseinrichtungen (17) mit Gasdüsen (18) zur Erzeugung eines das Metallband (1) unterstützenden Gaspolsters zumindest innerhalb der Durchlauf-Beschichtungskammer (10) vorgesehen sind.

2. Anlage nach Anspruch 1, **dadurch gekennzeichnet, daß** in der Durchlauf-Beschichtungskammer (10) an sich quer zur Längserstreckung der Durchlauf-Beschichtungskammer (10) erstreckenden Gasdilsenbalken angeordnete Gasdüsen vorgesehen sind.

3. Anlage nach Anspruch 1 oder 2, **dadurch gekennzeichnet, daß** vor der Durchlauf-Beschichtungskammer (10) eine den Bandanfang (16) des Metallbandes (1) mit einer Querkrümmung versehende Biegeeinrichtung (6) vorgesehen ist.

4. Anlage nach einem oder mehreren der Ansprüche 1 bis 3, **dadurch gekennzeichnet, daß** innerhalb der Durchlauf-Beschichtungskammer (10) Klemmbacken (22) zum Erfassen des Bandanfangs (16) des Metallbandes (1) vorgesehen sind, die unter Klemmung des Metallbandes (1) in dessen Förderrichtung bewegbar und unter Freilassung des Metallbandes (1) retour bewegbar sind (Fig. 3).

5. Anlage nach einem oder mehreren der Ansprüche 1 bis 4, **dadurch gekennzeichnet, daß** die Beschichtungskammer mit einer Einrichtung zum Aufsprühen oder Bedampfen oder Roll-coaten des Beschichtungsmaterials versehen ist.

## Claims

1. An installation for coating a metal strip (1), in particular for the metallic coating of a steel strip, comprising a coil unwinding station (2), a continuous coating chamber (10) and a coil winding station (15) arranged after the continuous coating chamber (10) as well as strip guiding means (17) between the coil unwinding station (2) and the continuous coating chamber (10) as well as between the continuous coating chamber (10) and the coil winding station (15), **characterized in that** strip guiding means (17) comprising gas nozzles (18) for the generation of a gas cushion supporting the metal strip (1) are provided at least inside the continuous coating chamber (10).

2. An installation according to claim 1, **characterized in that** gas nozzles arranged on gas nozzle beams extending transversely to the longitudinal dimension of the continuous coating chamber (10) are provided in the continuous coating chamber (10).

3. An installation according to claim 1 or 2, **characterized in that** a bending device (6) imparting a transverse bend to the front end (16) of the metal strip (1) is provided in front of the continuous coating chamber (10).

4. An installation according to one or several of claims 1 to 3, **characterized in that** clamping jaws (22) for gripping the front end (16) of the metal strip (1) are provided inside the continuous coating chamber (10), which jaws are movable in the conveying direction of the metal strip (1) while clamping the same and are movable back upon releasing the metal strip (1) (Fig. 3).

5. An installation according to one or several of claims 1 to 4, **characterized in that** the coating chamber is provided with a device for spraying or vapour-depositing or roll-coating the coating material.

## Revendications

1. Installation de revêtement d'une bande métallique (1), en particulier pour déposer un revêtement métallique sur un feuillard d'acier, comportant un poste de déroulement de la bobine (2), une chambre de revêtement à passage continu (10) et un poste d'enroulement de la bobine (15) monté en aval de la chambre de revêtement à passage continu (10), ainsi que des dispositifs de guidage de la bande (17) entre le poste de déroulement de la bobine (2) et la chambre de revêtement à passage continu (10), ainsi qu'entre la chambre de revêtement à passage continu (10) et le poste d'enroulement de la bobine (15), **caractérisée en ce qu'**il est prévu des dispositifs de guidage de la bande (17) avec des tuyères à gaz (18) destinées à générer un matelas de gaz supportant la bande métallique (1) au moins à l'intérieur de la chambre de revêtement à passage continu (10).

2. Installation selon la revendication 1, **caractérisée en ce que**, dans la chambre de revêtement à passage continu (10), il est prévu des tuyères à gaz agencées sur des barres qui s'étendent transversalement à la dimension longitudinale de la chambre de revêtement à passage continu (10).

3. Installation selon la revendication 1 ou 2, **caractérisée en ce que**, en amont de la chambre de revêtement à passage continu (10), il est prévu un dispositif de pliage (6) destiné à réaliser une courbure transversale sur le début (16) de la bande métallique (1).

4. Installation selon une ou plusieurs des revendications 1 à 3, **caractérisée en ce que**, à l'intérieur de la chambre de revêtement à passage continu (10), il est prévu des mâchoires de serrage (22), qui sont destinées à saisir le début (16) de la bande métallique (1) et qui, pendant le serrage de la bande métallique (1), sont aptes à se déplacer dans la direction de défilement de celle-ci et, après le relâchement de la bande métallique (1), sont aptes à se déplacer pour revenir dans leur position initiale (figure 3).

5. Installation selon une ou plusieurs des revendications 1 à 4, **caractérisé en ce que** la chambre de revêtement est équipée d'un dispositif destiné à déposer le matériau de revêtement par pulvérisation ou métallisation sous vide ou par application au rouleau (roll-coating).
